# EUROPEAN PATENT SPECIFICATION

(11) **EP 0 701 324 B1**
(45) Date of publication and mention of the grant of the patent: **27.12.2000**
(21) Application number: 94926369.3
(22) Date of filing: 08.09.1994
(51) Int. Cl.: H03K 5/00

(54) **CLOCK MULTIPLYING SIGNAL CONTROL CIRCUIT**
STEUERSCHALTUNG FÜR TAKT-MULTIPLIZIERER
CIRCUIT DE COMMANDE DE SIGNAUX PERMETTANT DE MULTIPLIER DES SIGNAUX D'HORLOGE

(30) Priority: 17.09.1993 JP 23153893
(43) Date of publication of application: 13.03.1996
(73) Proprietor: Oki Electric Industry Company, Limited, Tokyo 105 (JP)
(72) Inventor: MUKOUJIMA, Toshiaki Oki Electric Industry Co., Ltd, Tokyo 105 (JP)
(74) Representative: Read, Matthew Charles
(86) International application number: PCT/JP94/01481
(87) International publication number: WO 95/08217

(56) References cited:
- GB-A- 1 469 374
- JP-A- 3 001 730
- JP-A- 50 137 646
- JP-A- 51 130 156
- JP-A- 61 173 518
- JP-B- 58 041 694

## Description

This invention relates to a control circuit for an output clock of a clock multiplier used for optical transmission equipments and multiplexers in a digital transmission system. More specifically, it relates to a control circuit for clock multiplier capable, when a multiplied signal comes out at the output due to influences of noise or whatever even while no input signal is applied, of controlling the output signal.

A clock multiplier may be required, for example, in a general digital system, when the speed of a main processing unit is set at V/x to get phase margin regarding the processing in a system, in which processing is implemented by the speed V at the input and by the speed V at the output. To output from the system such a signal processed at the speed V/x as a signal with the speed V, data must be converted into data with the speed V on the basis of a clock multiplied x times of the clock having the speed V/x used for processing.

A clock multiplier is required in the situations described above. In a conventional clock multiplier, a limiter amplifier is provided in order for restituting a loss occurring by when a signal is fed at the input terminal of the clock multiplier, a loss caused by an insertion of a band pass filter, and the like. To sufficiently restitute such losses, a limiter amplifier having its gain of about 32 dB is typically used. However, when the limiter amplifier has a high gain, input of noise may be amplified even where no input signal is applied. Upon amplification of noise, a signal having amplitude and frequency equivalent to the multiplied clock obtainable when an input signal is given, can come out at the output terminal.

Though no document properly discloses a control circuit for clock multiplier that controls outputs of such a multiplier, Japanese Patent Unexamined Publication Sho No. 56-47,139, is known regarding control of an output clock. The control circuit shown in the Patent Publication has constitution that a circuit detecting signal loss and a gate circuit are inserted between the output of the regenerate clock signal and an output terminal. With the control circuit thus constituted, particularly when a high frequency signal is used as a clock signal, the gate circuit to be inserted is required to have high performance electrical characteristics, representatively, such as rise time. Such a gate circuit, however, is expensive and costs so much. The number of connection points for high frequency signal increases in order to insert the gate circuit, thereby inducing waveforms of the clock signal to be impaired.

Hence, it is an object of the invention to provide a control circuit for clock multiplier solving problems arising out of such conventional clock multiplier and control circuit.

According to the present invention there is provided a clock multiplier configured to receive an input signal comprising a clock signal and to output an output signal comprising a frequency-multiplied clock signal, the clock multiplier comprising amplifier means for receiving an intermediate signal derived from the input signal and comparing the intermediate signal with a bias reference level, peak detection means for determining the amplitude of the input signal, comparator means for comparing the amplitude of the input signal with a first reference voltage, which is less than the amplitude of the clock signal and a switching means for providing the amplifier means with the bias reference level so as to permit or suppress amplification of the intermediate signal in dependence upon the comparison of the amplitude of the input signal and the first reference voltage.

The switching means may be configured to select a maximum voltage level as the bias reference level when the input signal is less than the first reference voltage so as to suppress amplification of the intermediate signal.

The switching means may be configured to select an open circuit when the input signal is greater than the first reference voltage and the amplifier means sets the bias reference level to a self-bias voltage so as to permit amplification of the intermediate signal.

The switching means may comprise an analog switch circuit whose input is controlled by the output of the comparator means.

According to the present invention there is also provided a method of operating a clock multiplier comprising receiving an input signal that comprises a clock signal, outputting an output signal comprising a frequency-multiplied clock signal, comparing an intermediate signal derived from the input signal with a bias reference level, measuring the amplitude of the input signal, comparing the amplitude of the input signal with a first reference voltage, which is less than the amplitude of the clock signal and providing the amplifier means with the bias reference level so as to suppress or allow amplification of the intermediate signal depending on the outcome of the comparison.

The providing of the bias reference level may comprise selecting a maximum voltage level when the input signal is less than the first reference voltage and supplying the maximum voltage level as the bias reference level to the amplifier means so as to suppress amplification of the intermediate signal.

The providing of the bias reference level may comprise selecting an open circuit when the input signal is greater than the first reference voltage and, at the amplifier means, setting the bias reference level to a self-bias voltage so as to permit amplification of the intermediate signal.

An embodiment of the present invention will now be described, by way of example, with reference to the following drawings, in which:-
Figure 1 is a control circuit for clock multiplier according to the invention;
Figure 2 is a timing chart for the control circuit for clock multiplier according to the invention and
Figure 3 is a peak detection circuit.

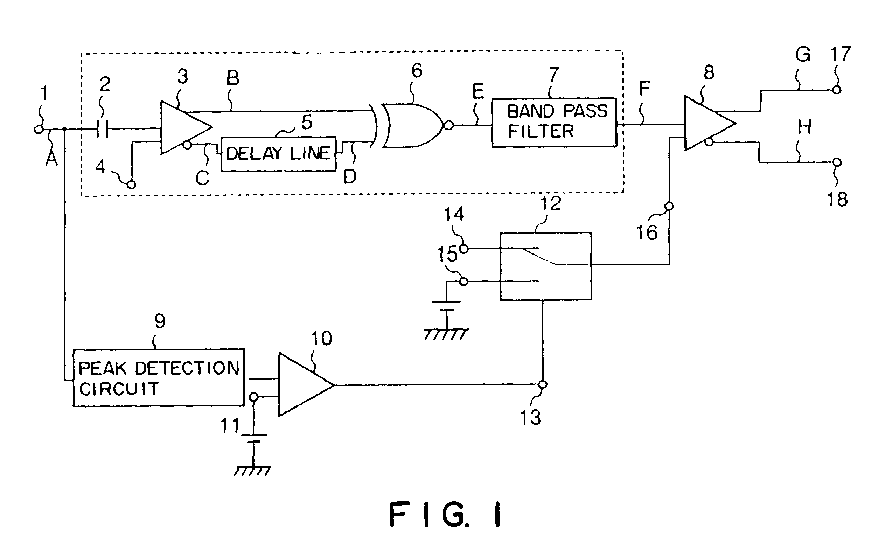

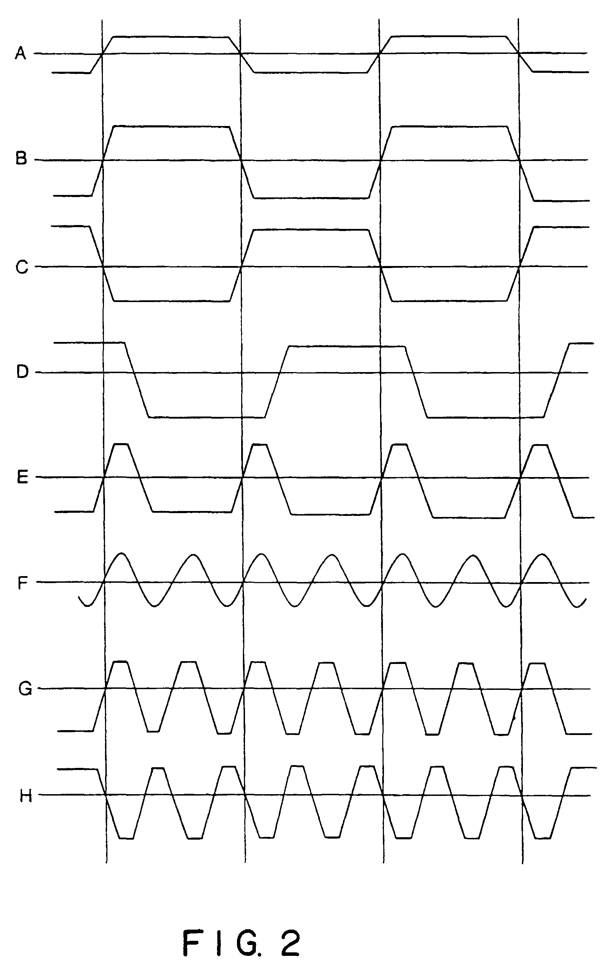

Figure 1 is a control for clock multiplier according to the invention. Fig. 2 is a timing chart for the control circuit for clock multiplier in Fig. 1. A constitutional example of the clock multiplier is shown by a portion enclosed by a broken line in Fig. 1. An input terminal 1 is connected to a capacitor 2. The capacitor 2 is connected to a first limiter amplifier 3. A terminal 4 is an open side of the first limiter amplifier 3. An output of the first limiter amplifier 3 is connected to an exclusive-nor gate 6. A negative output of the first limiter amplifier 3 is connected to the exclusive-nor gate 6 through a delay line 5. An output of the exclusive-nor gate 6 is connected to a band pass filter 7. An output of the band pass filter 7 is connected to a second limiter amplifier 8. The second limiter amplifier 8 is connected to an output terminal 17 and an output terminal 18 fed with a signal reversed of the signal at the terminal 17.

Now, a connection relationship among portions constituting a control circuit will be described. The input terminal 1 is connected to a peak detection circuit 9. The peak detection circuit 9 is connected to the comparator 10. A reference voltage input terminal 11 is also connected to the comparator 10. The comparator 10 is connected to an analog switch 12 through an input switching terminal 13. The analog switch 12 is formed with input terminals 14, 15. The analog switch 12 is further connected to the limiter amplifier 8 through a logic threshold reference terminal 16.

Operation of the control circuit for clock multiplier thus constituted will be described. First, operation of a portion constituting a clock multiplier will be described. A clock signal having a cycle 2T is fed at the input terminal 1. The waveform of the input signal A is shown by A in Fig. 2. The input signal indicated by A may have a smaller amplitude due to loss and the like during a step to be fed to the input terminal 1. Hence, the signal A is first fed to the capacitor 2 of the clock multiplier circuit to adjust its level. The output signal from the capacitor 2 is fed to the first limiter amplifier 3. The limiter amplifier is defined as an amplifier setting a limited value of an amplified signal. The limited amplifier here sets the limited value to the amplitude value of the signal to be fed. The amplitude of the signal A, impaired due to the loss, is restituted by reforming the waveform at the first limiter amplifier 3. B in Fig. 2 shows a signal which restituted its amplitude from reforming its waveform.

The signal B is fed to the exclusive-nor gate 6. If four times multiplying is considered, and if the cycle and the pulse width are set to 2T, T, respectively, the reverse signal C of the signal B is fed to the delay line 5, thereby being delayed by 1/4T cycle. In this control circuit for clock multiplier, if the number of multiplying times is set to N, the signal is delayed by (1/N)T. The signal D delayed at the delay line 5 is also fed to the exclusive-nor gate 6. Therefore, the signals B, D are fed to the exclusive-nor gate 6. A logic operation of exclusive-nor of the signals B, D is implemented at the exclusive-nor gate 6 and provides signal E. The waveform of the signal E is shown by E in Fig. 2. The signal E is fed to the band pass filter 7. The band pass filter 7 is constituted of a surface acoustic wave (SAW) filter. The band pass filter 7 can extract a necessary frequency signal of the multiplied clock. In this embodiment, in consideration for four times multiplying, a waveform having a four times frequency is extracted, and then signal F is obtained. The waveform of the signal F as the output of the band pass filter 7 is shown by F in Fig. 2. As shown in Fig. 2, the signal F as the multiplied signal of the input signal A has deteriorated waveform due to insertion loss of the SAW filter, electrical power loss when passing the band pass filter 7, or whatever. To restitute such losses, the output of the band pass filter 7 is fed to the second limiter amplifier 8. The second limiter amplifier 8 is also an amplifier similar to the first limiter amplifier 3, and sets the limited value of the amplified signal to an amplitude of a multiplied signal to be obtained. The second limiter amplifier 8 restitutes deteriorations of the waveform of the signal F.

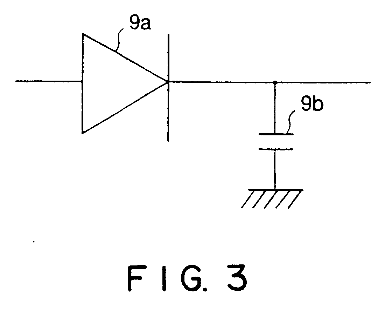

Next, operation of a portion constituting the control circuit will be described. The signal A fed to the input terminal 1 is also fed to the capacitor 2 of the clock multiplier as well as to the peak detection circuit 9. The constitution of the peak detection circuit 9 is shown in Fig. 3. The peak detection circuit 9 in this embodiment is constituted of a diode 9a and a capacitor 9b. The diode 9a passes a signal having voltage of the forward bias or above of the diode 9a and does not pass a signal having voltage of the forward bias or below. A diode whose forward bias is less than the amplitude value of the input signal is used here as diode 9a. By providing the diode 9a, when a clock having a smaller amplitude than the forward bias of the diode 9a is fed, the signal cannot pass through it, so that zero level is obtained from the output of the peak detection circuit 9, and so that the circuit operates similarly when noise is applied as described below. Although in this embodiment the diode 9a and the capacitor 9b are formed for the peak detection circuit 9, the peak values can be detected by operation described below even if only capacitors constitute the peak detection circuit 9.

The signal fed to the peak detection circuit 9, after passing the diode 9a, is gradually charged at the capacitor 9b up to the peak value of the amplitude. Now, if there is an input clock, it is charged up to the peak value of the amplitude of the signal A, and therefore, the peak detection circuit 9 detects the peak value.

The peak value is fed to the comparator 10. The peak value of the amplitude is compared at the comparator 10 with the first reference voltage fed from the reference voltage input terminal 11. The first reference voltage is previously set to a value less than the amplitude of the clock signal to be fed. The comparator 10 output a signal of H level when the peak value of the amplitude as the output of the peak detection circuit 9 is greater than the first reference voltage, and output a signal of L level when less. Therefore, where there is an input clock, the peak value of the amplitude detected at the peak detection circuit 9 is always greater than the first reference voltage, so that the output of the comparator 10 becomes the signal of H level. The output signal of the comparator 10 is fed to the input switching terminal 13 of the analog switching circuit 12.

When the signal fed to the input switching terminal 13 is at H level, the input terminal 14 is selected as the input of the analog switching circuit 12. The analog switching circuit 12 controls the value of the second reference voltage inside the second limiter amplifier 8 according to the value of the voltage of the input terminal to be connected. The analog switching circuit 12 is connected to the second limiter amplifier 8 through the logic threshold reference terminal 16. When the input terminal 14 is selected as an input of the analog switching circuit 12, because the input terminal 14 is being open, the second reference voltage controlled through the logic threshold reference terminal 16 falls in a condition that it is self-biased to the DC voltage of the second limiter amplitude 8. The second limiter amplifier 8 outputs a signal of H level when the input signal is greater than the second reference voltage, and outputs a signal of L level when the input signal is less.

Accordingly, signal G restituting the loss in the signal F fed to the second limiter amplifier 8 is obtained at the output terminal 17 of the second limiter amplifier 8. Reverse signal H of the signal G is obtained at the output terminal 18. The waveforms of the signals G, H are shown by G, H, respectively, in Fig. 2. The clock output signal that the input signal is multiplied four times is thus obtained at the output terminals 17, 18.

There describes operation when no input signal is applied to the input terminal 1. Noise can eventually be fed more or less even if no input signal is applied. In the portion of the clock multiplier, where the first limiter amplifier 3 has a high gain, noise would be eventually amplified. In such a situation, the signal is multiplied at the portion of the clock multiplier in the same manner when the input signal is given, and the multiplied signal is obtained as the signal F and fed to the second limiter amplifier 8.

Meanwhile, this noise is also fed to the portion of the control circuit. Noise having small amplitude is not recognized because of the diode 9a of the peak detection circuit 9. Although a portion at which its amplitude is large in the noise that passed through the diode 9a is charged at the capacitor 9b, it is little charged because the portion that no input is given to the capacitor 9b is long, and therefore, the value detected as the peak value at the peak detection circuit 9 is nearly zero level. This nearly zero level signal is compared at the comparator 10 with the first reference voltage at the reference voltage input terminal 11. The first reference voltage has a slightly less value than the value of the amplitude of the input clock signal, and is greater than the nearly zero level. Therefore, because the peak value of the detected amplitude is less than the first reference voltage, the output of the comparator 10 becomes a signal of L level. When the L level output of the comparator 10 is fed to the input switching control terminal 13, the input terminal 15 is selected as the input of the analog switching circuit 12. The input terminal 15 is set to the maximum voltage level of the signal fed to the second limiter amplifier. The second reference voltage controlled through the logic threshold reference terminal 16 is therefore set to the maximum voltage level of the input signal of the second limiter amplifier.

If the signal F fed to the second limiter amplifier 8 is compared with the second reference voltage, the value of the signal F is always less than the second reference voltage. Therefore, a signal of L level as of information that the signal F is less than the second reference voltage is obtained as the output of the second limiter amplifier 8, and a stable signal of L level is obtained at the output terminal 17.

Thus, even when noise is amplified and multiplied signal is eventually obtained since the limiter amplifier provided in the portion of the multiplier has a high gain, the output signal can be controlled by, at the portion of the control circuit, detecting that there is no input signal and by comparing at the limiter amplifier with the reference voltage.

As the constitution of the clock multiplier, various structures, not limited to above, can be thought. Furthermore, the portion of the control circuit, used for the control circuit for clock multiplier, can be used for control of output signals of receivers or the like except the clock multiplier.

As described above, the control circuit for clock multiplier is effectively used for high speed digital signal pressing equipments as optional transmission equipment, multiplier, switching system.

## Claims

1. A clock multiplier configured to receive an input signal comprising a clock signal (A) and to output an output signal comprising a frequency-multiplied clock signal (G, H), the clock multiplier comprising:
amplifier means (8) for receiving an intermediate signal (F) derived from the input signal and comparing the intermediate signal with a bias reference level (16);
peak detection means (9) for determining the amplitude of the input signal;
comparator means (10) for comparing the amplitude of the input signal with a first reference voltage (11), which is less than the amplitude of the clock signal and **characterised by**
a switching means (12) for providing the amplifier means with the bias reference level so as to permit or suppress amplification of the intermediate signal in dependence upon the comparison of the amplitude of the input signal and the first reference voltage.

2. A clock multiplier according to claim 1 wherein the switching means (12) is configured to select a maximum voltage level (15) as the bias reference level when the input signal is less than the first reference voltage so as to suppress amplification of the intermediate signal.

3. A clock multiplier according to claim 1 wherein the switching means (12) is configured to select an open circuit (14) when the input signal is greater than the first reference voltage and the amplifier means (8) sets the bias reference level to a self-bias voltage so as to permit amplification of the intermediate signal.

4. A clock multiplier according to any preceding claim wherein the switching means (12) comprises an analog switch circuit whose input is controlled by the output (13) of the comparator means (10).

5. A method of operating a clock multiplier comprising:
receiving an input signal that comprises a clock signal (A);
outputting an output signal comprising a frequency-multiplied clock signal (G, H);
comparing an intermediate signal (F) derived from the input signal relative with a bias reference level;
measuring (9) the amplitude of the input signal;
comparing (10) the amplitude of the input signal with a first reference voltage (11), which is less than the amplitude of the clock signal and
providing the amplifier means (8) with the bias reference level so as to suppress or allow amplification of the intermediate signal depending on the outcome of the comparison.

6. A method according to claim 5 wherein the providing of the bias reference level comprises selecting a maximum voltage level (15) when the input signal is less than the first reference voltage and supplying the maximum voltage level as the bias reference level to the amplifier means (8) so as to suppress amplification of the intermediate signal.

7. A method according to claim 5 wherein the providing of the bias reference level comprises selecting an open circuit (14) when the input signal is greater than the first reference voltage and, at the amplifier means (8), setting the bias reference level to a self-bias voltage so as to permit amplification of the intermediate signal.

## Patentansprüche

1. Taktmultiplizierer, der konfiguriert ist, ein Eingangssignal zu empfangen, das ein Taktsignal (A) umfaßt, und ein Ausgangssignal auszugeben, das ein frequenzmultipliziertes Taktsignal (G, H) umfaßt, wobei der Taktmultiplizierer folgendes umfaßt:
eine Verstärkereinrichtung (8) zum Empfangen eines Zwischensignals (F), das von dem Eingangssignal abgeleitet wurde, und Vergleichen des Zwischensignals mit einem Vorspannungs-Referenzpegel (16);
eine Spitzen-Detektionseinrichtung (9) zum Ermitteln der Amplitude des Eingangssignals;
eine Komparatoreinrichtung (10) zum Vergleichen der Amplitude des Eingangssignals mit einer ersten Referenzspannung (11), die kleiner ist als die Amplitude des Taktsignals;
und gekennzeichnet ist durch
eine Schalteinrichtung (12) zum Zuführen des Vorspannungs-Referenzpegels an die Verstärkereinrichtung, um die Verstärkung des Zwischensignals in Abhängigkeit vom Vergleich der Amplitude des Eingangssignals mit der ersten Referenzspannung zuzulassen oder zu unterdrücken.

2. Taktmultiplizierer nach Anspruch 1, bei dem die Schalteinrichtung (12) konfiguriert ist, einen maximalen Spannungspegel (15) als den Vorspannungs-Referenzpegel auszuwählen, wenn das Eingangssignal kleiner ist als die erste Referenzspannung, um die Verstärkung des Zwischensignals zu unterdrücken.

3. Taktmultiplizierer nach Anspruch 1, bei dem die Schalteinrichtung (12) konfiguriert ist, einen offenen Stromkreis (14) auszuwählen, wenn das Eingangssignal größer als die erste Referenzspannung ist, und bei dem die Verstärkereinrichtung (8) den Vorspannungs-Referenzpegel auf eine Selbstvorspannung einstellt, um die Verstärkung des Zwischensignals zuzulassen.

4. Taktmultiplizierer nach einem der vorhergehenden Ansprüche, bei dem die Schalteinrichtung (12) einen analogen Schaltkreis umfaßt, dessen Eingang durch den Ausgang (13) der Komparatoreinrichtung (10) gesteuert wird.

5. Verfahren zum Betreiben eines Taktmultiplizierers, das folgendes umfaßt:
Empfangen eines Eingangssignals, das ein Taktsignal (A) umfaßt;
Ausgeben eines Ausgangssignals, das ein frequenzmultipliziertes Taktsignal (G, H) umfaßt;
Vergleichen eines Zwischensignals (F), das vom Eingangssignal abgeleitet wurde, mit einem Vorspannungs-Referenzpegel;
Messen (9) der Amplitude des Eingangssignals;
Vergleichen (10) der Amplitude des Eingangssignals mit einer ersten Referenzspannung (11), die kleiner ist als die Amplitude des Taktsignals, und
Zuführen des Vorspannungs-Referenzpegels an die Verstärkereinrichtung (8), um in Abhängigkeit vom Ergebnis des Vergleichs die Verstärkung des Zwischensignals zuzulassen oder zu unterdrücken.

6. Verfahren nach Anspruch 5, bei dem, wenn das Eingangssignal kleiner als die erste Referenzspannung ist, das Zuführen des Vorspannungs-Referenzpegels das Auswählen eines maximalen Spannungspegels (15) sowie das Anlegen des maximalen Spannungspegels als Vorspannungs-Referenzpegel an die Verstärkereinrichtung (8) umfaßt, um die Verstärkung des Zwischensignals zu unterdrücken.

7. Verfahren nach Anspruch 5, bei dem, wenn das Eingangssignal größer ist als die erste Referenzspannung, das Zuführen des Vorspannungs-Referenzpegels das Auswählen eines offenen Stromkreises (14) und, an der Verstärkereinrichtung (8), das Einstellen des Vorspannungs-Referenzpegels auf eine Selbstvorspannung umfaßt, um die Verstärkung des Zwischensignals zuzulassen.

## Revendications

1. Multiplicateur d'horloge configuré de façon à recevoir un signal d'entrée comprenant un signal d'horloge (A) et de façon à délivrer en sortie un signal de sortie comprenant un signal d'horloge multiplié en fréquence (G, H), le multiplicateur d'horloge comprenant :
des moyens formant amplificateur (8) pour recevoir un signal intermédiaire (F) dérivé du signal d'entrée et comparer le signal intermédiaire à un niveau de référence de polarisation (16) ;
des moyens de détection de pic (9) pour déterminer l'amplitude du signal d'entrée ;
des moyens formant comparateur (10) pour comparer l'amplitude du signal d'entrée à une première tension de référence (11), qui est inférieure à l'amplitude du signal d'horloge, et caractérisé par :
des moyens de commutation (12) pour communiquer aux moyens formant amplificateur le niveau de référence de polarisation de façon à permettre ou à supprimer l'amplification du signal intermédiaire en fonction de la comparaison de l'amplitude du signal d'entrée et de la première tension de référence.

2. Multiplicateur d'horloge selon la revendication 1, dans lequel les moyens de commutation (12) sont configurés de façon à sélectionner un niveau de tension maximal (15) comme niveau de référence de polarisation lorsque le signal d'entrée est inférieur à la première tension de référence de façon à supprimer l'amplification du signal intermédiaire.

3. Multiplicateur d'horloge selon la revendication 1, dans lequel les moyens de commutation (12) sont configurés de façon à sélectionner un circuit ouvert (14) lorsque le signal d'entrée est supérieur à la première tension de référence, et les moyens formant amplificateur (8) établissent le niveau de référence de polarisation à une tension d'auto-polarisation de façon à permettre l'amplification du signal intermédiaire.

4. Multiplicateur d'horloge selon l'une quelconque des revendications précédentes, dans lequel les moyens de commutation (12) comprennent un circuit de commutateur analogique dont l'entrée est commandée par la sortie (13) des moyens formant comparateur (10).

5. Procédé d'utilisation d'un multiplicateur d'horloge, comprenant :
la réception d'un signal d'entrée qui comprend un signal d'horloge (A) ;
la délivrance en sortie d'un signal de sortie comprenant un signal d'horloge multiplié en fréquence (G, H) ;
la comparaison d'un signal intermédiaire (F) dérivé du signal d'entrée à un niveau de référence de polarisation ;
la mesure (9) de l'amplitude du signal d'entrée ;
la comparaison (10) de l'amplitude du signal d'entrée à une première tension de référence (11), qui est inférieure à l'amplitude du signal d'horloge ; et
la délivrance aux moyens formant amplificateur (8) du niveau de référence de polarisation de façon à supprimer ou à permettre l'amplification du signal intermédiaire en fonction du résultat de la comparaison.

6. Procédé selon la revendication 5, dans lequel la délivrance du niveau de référence de polarisation comprend la sélection d'un niveau de tension maximal (15) lorsque le signal d'entrée est inférieur à la première tension de référence et la délivrance du niveau de tension maximal comme niveau de référence de polarisation aux moyens formant amplificateur (8) de façon à supprimer l'amplification du signal intermédiaire.

7. Procédé selon la revendication 5, dans lequel la délivrance du niveau de référence de polarisation comprend la sélection d'un circuit ouvert (14) lorsque le signal d'entrée est supérieur à la première tension de référence, et, dans les moyens formant amplificateur (8), l'établissement du niveau de référence de polarisation à une tension d'auto-polarisation de façon à permettre l'amplification du signal intermédiaire.
